Europäisches Patentamt

European Patent Office

Office européen des brevets

(19)

(11) **EP 1 013 801 A1**

(12) **EUROPEAN PATENT APPLICATION**

(43) Date of publication:
**28.06.2000 Bulletin 2000/26**

(51) Int. Cl.$^7$: **C30B 11/00**, C30B 15/00,
C30B 29/48, C30B 29/40

(21) Application number: **99124302.3**

(22) Date of filing: **06.12.1999**

(84) Designated Contracting States:
**AT BE CH CY DE DK ES FI FR GB GR IE IT LI LU MC NL PT SE**
Designated Extension States:
**AL LT LV MK RO SI**

(30) Priority: **21.12.1998 EP 98124186**

(71) Applicant:
**PIRELLI CAVI E SISTEMI S.p.A.**
**20126 Milano (IT)**

(72) Inventors:
• **Zanotti, Lucio**
  **43100 Parma (IT)**

• **Zha, Mingzheng**
  **43100 Parma (IT)**
• **Görög, Tamas**
  **2000 Szentendre (HU)**
• **Zuccalli, Giovanni**
  **43058 Sorbolo (Parma) (IT)**
• **Zappettini, Andrea**
  **42100 Reggio Emilia (IT)**

(74) Representative:
**Giannesi, Pier Giovanni et al**
**Pirelli S.p.A.**
**Industrial Property Dept.**
**Viale Sarca, 222**
**20126 Milano (IT)**

(54) **Process and apparatus for synthesizing and growing crystals**

(57)     A process for producing polycrystalline compounds of high purity and correct stoichiometry, comprising the steps of: placing stoichiometric amounts of at least two reactants in a first region; placing an amount of an encapsulant in a second region sufficient to completely surround the reactants when the encapsulant is in a molten state, the second region being suitable for the transfer of the encapsulant in a molten state into the first region and thew first and second regions being capable of being heated separately from each other; creating a suitable environment of gas around the first and second regions; heating said second region to a first temperature sufficient to melt the encapsulant while not heating the first region, the first region being maintained at a temperature sufficient to avoid vaporization of said reactants thus causing said encapsulant, in a molten state, to move from said second region into said first region and surround said reactants; heating the reactants to a second temperature sufficient to melt and cause reactants to react; and heating the reaction product to a third temperature sufficient to melt for a time sufficient to synthesize and homogenize.

FIG. 1

EP 1 013 801 A1

**Description**

## FIELD OF THE INVENTION

The present invention relates generally to a process and apparatus for synthesizing polycrystalline compounds and for growing monocrystals from such compounds. More particularly, the present invention relates to a process and apparatus for synthesizing Group II-VI and Group III-V polycrystalline compounds of high purity and correct stoichiometry, comprising one or more reactants or dopants which are of high volatility at a temperature below the melting point of the chosen encapsulant and for growing monocrystals from such compounds using known crystal growth techniques.

## BACKGROUND OF THE INVENTION

Many Group II-VI compounds, such as CdTe, are suitable for use in a wide variety of semiconductor applications, including optical applications, in the production of detectors for high-energy particles such as γ and x particles, and as substrates in structures with HgCdTe for use in infra-red radiation detectors and solar cells. For example, European Patent Application EP 0886167, in the name of the Applicant, describes, inter alia, an optical switching device that uses an indium-doped CdTe crystal. Such applications require the monocrystalline material to be of both high purity and of high crystallinity.

While the growth of high quality silicon-based monocrystals in bulk quantities has been possible for many years, this is not the case for Group II-VI and III-V compounds. The growth of monocrystals with the desired stoichiometry from various compounds of elements belonging to Groups II and VI, in particular from CdTe, is particularly complex because of the volatility of one or more of these elements and in some cases, large differences between the vapor pressures of the constituents of a compound at elevated temperatures and low thermal conductivity. Furthermore, in preparing the alloy, segregation of reactants can occur because of differences in composition of the solid and liquid phases in equilibrium at a given temperature, resulting in a non-uniform distribution of reactants, impurities, dopants or microphases in localized concentrations. Moreover, at the temperatures at which growth normally takes place, reaction of the reactants or compound with the container material can result in contamination of the crystal. Crystal growth can also be adversely affected by a high impurity content, dislocation density, or an excess of one of the constituents which is too high and/or non-uniform in distribution resulting in a non-stoichiometric compound and/or a crystal with impaired electronic properties.

The relevant art teaches various methods for synthesizing Group II-VI semiconductor compounds, among which are the solid-state reaction method and the vapor-phase synthesis method. N.N. Kolesnikov et al., "Growth and Characterization of P-Type $Cd_{1-x}Zn_xTe$ (x - 0.2, 0.3, 0.4)," J. Crystal Growth, Vol. 174, pp. 256-262 (1997), describe the synthesis of CdTe by solid-state reaction of Cd and excess Te in closed silica ampoules. The same article also describes the vapor-phase synthesis of ZnTe by the reaction at 1050°C of Zn and excess Te vapors, evaporated from separate sources, in closed silica ampoules.

F.P. Doty and J.F. Butler, "Properties of CdZnTe crystals grown by high pressure Bridgman method", J.Vac.Sci. Technol. B 10(4), pp. 1418-1422 (Jul/Aug 1992), describe a crystal growth process where the charge is heated on a programmed schedule for reaction and homogenization of the melt in high purity graphite crucibles with tight fitting caps to reduce evaporative loss of the charge.

Table I, of the same article, shows the charge lost during growth of CdZnTe crystals.

Various semiconductor monocrystal growth techniques for compounds of Group II-VI are also known in the art, particularly for the compound CdTe. One known growth technique is the Bridgman method of vertical type, (VB), or horizontal type, (HB), growth. In the article "Crystal Growth of Large-Area Single-Crystal CdTe and CdZnTe by the Computer-Controlled Vertical Modified-Bridgman Process," J. Crystal Growth, Vol. 86 (1988), pp. 111-117, S. Sen et al. describe a particular VB type growth method used to grow a CdTe crystal. The apparatus used includes a hot zone which is separate from a cold zone, the two zones being arranged vertically and being such as to allow control of the heat gradients between these zones. The polycrystal used for the growth is obtained by vapor-phase reaction of the components.

Yellin, N. and Szapiro, S., "Vapor Transport of Nonstoichiometric CdTe in Closed Ampoules," J. Crystal Growth, Vol. 69, No. pp. 555-60 (1984), describe a method of physical vapor transport ("PVT") growth. First, polycrystalline CdTe was synthesized by low temperature reaction of Cd and excess Te under high vacuum seal in a constant volume quartz ampoule. Next, the polycrystalline CdTe was transferred to growth ampoules and monocrystals were grown by the vertical unseeded vapor growth (VUVG) technique at a temperature of between 930-933°C.

Another known growth technique is the liquid encapsulant Czochralski (LEC) process. In Crystal Growth Processes (John Wiley & Sons, 1986) on pages 151-54 relating to the growth of GaAs, J.C. Brice describes such a method, the basis of which is that it does not have a vapor phase. The method involves placing a certain amount of the material to be grown and the encapsulant in a crucible heated by a radio-frequency field. The encapsulant melts first, so as to separate the molten material from the crucible and coats the crystal and the surface of the molten material. The seed crystal is brought to the surface of the liquid and is grown by known processes under pressure, but it is coated with encapsulant that prevents it from decomposing. $B_2O_3$ is mentioned as a suitable encapsulant.

U.S. Patent No. 4,740,264 describes a method of growth using float zone techniques in which a rod of crystalline material, such as GaAs, is placed in a support structure and an encapsulant, such as $B_2O_3$, having a lower melting point than the crystalline material, is placed between the crystalline material and the surrounding support structure. Prior to melting the rod, the container is heated, by use of resistance heating coils, to melt the encapsulant surrounding the rod, with the result that the support structure, the encapsulant and the rod are all heated. The support structure is moved longitudinally through a heated zone to progressively melt sections of the rod as in conventional float zone processes.

U.S. Patent No. 5,057,287 describes a method of growth for Group III-V and Group II-VI crystals in which a seed crystal (e.g. GaAs), precompounded crystal material (e.g. polycrystalline GaAs), and an encapsulant are placed in a vessel in a furnace, and are passed sequentially through three furnace zones. The first furnace zone is maintained at a temperature above the melting point of the encapsulant but below the melting point of the crystal material, the second furnace zone is shorter in length than the length of the vessel and is maintained at a temperature at least equal to the melting temperature of the crystal material, and the third furnace zone is maintained at a temperature above the melting point of the encapsulant but below the melting point of the crystal material.

Another method for growing Group III-V and Group II-VI crystals is described in U.S. Patent No. 5,131,975. According to that method, small pieces of boron oxide encapsulant are dispersed throughout a comminuted compound semiconductor charge in a crucible that also contains a seed crystal. The temperature of the crucible is first raised to a value above the melting point of the boron oxide, which allows the boron oxide to form a sufficiently uniform layer of liquid between the walls, the base of the crucible and the semiconductor still in the solid state. The temperature is then raised approximately to the melting point of the compound semiconductor material and the crystal growth proceeds according to the liquid encapsulant vertical cooling gradient growth process.

Tomoki Inada et al., "Growth of Semi-Insulating GaAs Crystals with Low Carbon Concentration Using Pyrolytic Boron Nitride Coated Graphite," Appl. Phys. Lett. 50(3), pp. 143-145 (January 19, 1987), describe a method for minimizing the incorporation of carbon into GaAs crystals grown by the *in situ* synthesis liquid encapsulated Czochralski method under an Ar gas ambient. The method involves the use of pyrolytic boron nitride coated graphite components in the large puller.

U.S. Patent No. 4,652,332 describes a method for synthesizing and growing $CuInSe_2$ (I-III-VI) monocrystals. The Applicant has noted an apparent error in the text of the above-mentioned US patent, which may indicate that temperatures indicated in degrees C in the text should in reality be expressed in degrees K. For example, in column 5, lines 21-22, it is stated that "the $B_2O_3$ begins to soften at approximately 700°C." The Handbook of Chemistry and Physics, p. B-79 ($66^{th}$ Edition, 1985-86) gives the melting point of $B_2O_3$ as 450°C. 450°C is 723° K. The method described comprises placing stoichiometric amounts of Cu, In and Se in a crucible, along with $B_2O_3$. The Cu, In, Se and $B_2O_3$ are heated under pressure by means of an RF induction heating coil. The increase in temperature causes liquefaction of the $B_2O_3$ and coats the Cu, In and Se placed in the crucible and also causes the Se to begin to evaporate significantly. However, because the $B_2O_3$ is relatively soft and close to melting, most of the selenium is confined in the crucible. As the temperature is raised, the Cu, In and Se inside the crucible form molten encapsulated $CuInSe_2$, and the temperature is further raised to homogenize the compound. Next, a crystal is grown by inserting a seed crystal through the encapsulant in contact with the molten $CuInSe_2$, and then raising it again at a suitable rate. The patent discloses that despite the presence of the encapsulant in combination with an excess pressure of 55-70 atmospheres, there is still some small loss of Se from the crucible during the process, which can prevent the stoichiometric growth of the crystal. To solve this problem, the patent teaches adding an extra 1.8% to 2.0% of Se to the crucible in order to compensate for these losses and to obtain final conditions that are correct for stoichiometric growth.

From the account outlined above, relating to the known techniques for the synthesis and growth of monocrystals which involve the use of a liquid encapsulant, it is clear that considerable efforts have been made to improve the quality of the crystal grown. These efforts include, among other things, modifying the growth apparatus, appropriately selecting the materials of apparatus construction, producing particular temperature gradients in the growing crystal or various temperature changes over time and even by adding excess amounts of reactants to compensate for their vaporization.

Applicants have found, however, no teaching in the prior art of using an encapsulant method for the synthesis of Group II-VI polycrystalline compounds from which Group II-VI monocrystals are grown.

This is likely due to the fact that many of the Group II and Group VI elements begin to vaporize significantly at temperatures below the melting temperature of encapsulants such as $B_2O_3$. Thus, in prior art processes where melting the encapsulant necessarily resulted in heating the reactants, before melting of the encapsulant and coating of the reactants was complete, one or more of the volatile reactants would begin to vaporize unimpeded by the encapsulant resulting in non-stoichiometric polycrystalline compounds. Consequently, because the starting materials for monocrystal growth were non-stoichiometric, the above described growth methods would produce Group II-VI monocrystals having incorrect stoichiometry and/or impaired electronic properties.

Inventors have determined in particular that the solid-state reaction method does not ensure the complete reaction of the elements. A polycrystal obtained by this method can be strongly non-stoichiometric. A non-correct stoichiometry can occur also with the closed ampoule syntheses method, such as the one described in the cited paper by F.P. Doty et al.

Inventors have observed that the vapor phase synthesis is, in general, used for small productions of compounds and requires a long synthesis time. Furthermore, the apparatus used to perform this method are complex due to the requirement of avoiding losses of reactants' vapors. Cd and Te vapors, for example, are dangerous in that they can cause cancer.

## SUMMARY OF THE INVENTION

In accordance with the invention as embodied and broadly described herein, the present invention in one aspect includes a process for producing Group II-VI or Group III-V polycrystalline compounds of high purity and correct stoichiometry. The process comprises heating an encapsulant to a first temperature sufficient to melt the encapsulant; surrounding stoichiometric amounts of at least two reactants with the encapsulant in a molten state wherein during encapsulation the reactants do not achieve a temperature sufficient to cause vaporization of one or more of the reactants; and forming a polycrystalline Group II-VI or Group III-V compound from the reactants.

Typically, the step of surrounding stoichiometric amounts of at least two reactants with the encapsulant in a molten state further comprises heating said reactants surrounded by said encapsulant to a second temperature sufficient to melt said reactants and cause said reactants to react with each other and form a reaction product; and heating said reaction product to a third temperature sufficient to melt said reaction product and for a time sufficient to synthesize and homogenize said reaction product.

The present invention also includes a process for producing polycrystalline compounds of high purity and correct stoichiometry, comprising the steps of placing stoichiometric amounts of at least two reactants in a first region; placing an amount of an encapsulant in a second region sufficient to completely surround the reactants when the encapsulant is in a molten state, the second region being suitable for the transfer of the encapsulant in a molten state into the first region and the first and second regions being capable of being heated separately from each other; creating an environment of gas around the first and second regions and pressurizing the environment to a pressure substantially above the vapor pressure of the most volatile of the reactants at a selected maximum operating temperature; heating the second region to a first temperature sufficient to melt the encapsulant while not heating the first region, the first region being maintained at a temperature sufficient to avoid vaporization of the reactants thus causing the encapsulant, in a molten state, to move from the second region into the first region and surround the reactants; heating the reactants surrounded by the encapsulant to a second temperature sufficient to melt the reactants and cause the reactants to react with each other and form a reaction product; and heating the reaction product to a third temperature sufficient to melt the reaction product and for a time sufficient to synthesize and homogenize the reaction product.

The present invention further includes a process for producing polycrystalline compounds of high purity and correct stoichiometry, comprising the steps of: a) placing stoichiometric amounts of at least two reactants in a first region of a container; b) placing an amount of an encapsulant in a second region of the container sufficient to completely surround the reactants when the encapsulant is in a molten state, the second region being suitable for the transfer of the encapsulant in a molten state into the first region and the second region being immediately above and adjacent to the first region and the first and second regions being capable of being heated separately from each other; c) placing the container in an enclosed vertically oriented chamber; d) creating an environment of gas in the container and pressurizing the environment to a pressure substantially above the vapor pressure of the most volatile of the reactants at a selected maximum operating temperature; e) heating the second region to a first temperature sufficient to melt the encapsulant while maintaining the first region at a temperature sufficient to avoid vaporization of the reactants thus causing the encapsulant, in a molten state, to move from the second region into the first region and surround the reactants; f) heating the reactants surrounded by the encapsulant to a second temperature sufficient to melt the reactants and cause the reactants to react with each other and form a reaction product; g) heating the reaction product to a third temperature sufficient to melt the reaction product and for a time sufficient to synthesize and homogenize the reaction product.

Additionally, the process comprises the steps after step (g) of: cooling said reaction product surrounded by said encapsulant to a temperature below the melting point of said reaction product but above the melting point of said encapsulant; and separating said reaction product from said encapsulant.

Preferably, said reactants comprise at least one Group II element and at least one Group VI element or at least one Group III element and at least one Group V element. More preferably, said reactants are Cd and Te.

Preferably, the container into which the reactants are placed is associated with at least one other container. More preferably, a crucible is removably inserted within said container.

Advantageously, said encapsulant, employed in said processes for producing polycrystalline compounds, is $B_2O_3$.

Preferably, said inert gas, employed in said processes for producing polycrystalline compounds, is argon gas.

Preferably, pressure in said chamber is between about 10 atm and about 100 atm.

More preferably, the pressure in said chamber is about 20 atm.

Preferably, said first temperature, in step (e) is at least the melting point of the encapsulant.

Preferably, said second temperature, in step (f) is at least the melting point of the highest melting reactant.

Preferably, said third temperature, in step (g) is at least the melting point of the reaction product.

Typically, said reaction product is a polycrystalline compound. Preferably, said reaction product is CdTe.

In another aspect, the present invention includes the polycrystalline compound produced in accordance with the said process for producing polycrystalline compound. Preferably, said polycrystalline compound has a purity of at least about 5N.

Preferably, said second region of said process for producing polycrystalline compound, contains a heating element. Advantageously, said encapsulant is melted in step (e) by moving said container within said chamber relative to an electrical source within said chamber sufficient for an electric current from said electrical source to induce an electric current in said heating element without inducing a current in said reactants in said first region.

Preferably, in said process for producing polycrystalline compound said reactants are heated in step (f) by moving said container within said chamber relative to an electrical source within said chamber sufficient for an electric current from said electrical source to induce a current in said reactants.

Preferably, during step (g) said reaction product is rotated.

Preferably, said heating element is in contact with said encapsulant.

Preferably, said heating element is selected from the group consisting of liquid gallium or liquid indium. More preferably, said heating element is in a receptacle within said container.

Preferably, said heating element consists essentially of a graphite disc coated with pyrolytic boron nitride.

In another aspect, the present invention includes a process for producing a monocrystal of high purity and correct stoichiometry from a polycrystalline compound produced by said process, wherein the process further comprises the steps of: placing a seed monocrystal in a housing in said first region of said container, performing steps (a) through (g); and gradually lowering said container, relative to said chamber, such that the temperature of said first region is gradually reduced and said monocrystal is grown.

In another aspect, the present invention includes a process for producing an encapsulated reactant composition comprising the steps of: heating an encapsulant to a first temperature sufficient to melt the encapsulant; surrounding stoichiometric amounts of at least two reactants with the encapsulant in a molten state before the reactants achieve a temperature sufficient to cause vaporization of one or more of the reactants wherein the reactants comprise at least one Group II element and at least one Group VI element.

The present invention also includes an encapsulated reactant composition comprising at least two reactants surrounded by an encapsulant wherein the reactants comprise at least one Group II element and at least one Group VI element or at least one Group III element and at least one Group V element.

In another aspect, the present invention includes a polycrystalline compound comprising at least one Group II element and at least one Group VI element or at least one Group III element and at least one Group V element and having a purity of at least about 99.998% and wherein none of the elements comprising the compound deviates from stoichiometric composition by more than about 0.01 mol%.

In another aspect, the present invention includes a process for producing a monocrystal of high purity and correct stoichiometry, comprising the steps of:

a) heating an encapsulant to a first temperature sufficient to melt the encapsulant; b) surrounding stoichiometric amounts of at least two reactants with the encapsulant in a molten state before the reactants achieve a temperature sufficient to cause vaporization of one or more of the reactants, wherein the reactants comprise at least one Group II element and at least one Group VI element; c) heating the reactants surrounded by the encapsulant to a second temperature sufficient to melt the reactants and cause the reactants to react with each other and form a reaction product; d) heating the reaction product to a third temperature sufficient to melt the reaction product and for a time sufficient to synthesize and homogenize the reaction product; e) forming a monocrystal from the reaction product. Preferably, said encapsulant in step (a) forms a liquid. Preferably, said monocrystal in step (e) is formed by growing.

In a further aspect, the present invention includes a process for producing a monocrystal of high purity and correct stoichiometry, comprising the steps of: producing an encapsulated reaction product according to the said process for producing an encapsulant reaction product; heating said reaction product to a molten state; inserting a seed monocrystal into said reaction product; and gradually raising said seed monocrystal out of said molten reaction product.

In another aspect, the present invention includes a monocrystal of high purity and correct stoichiometry comprising at least one Group II element and at least one Group VI element or at least one Group III element and at least one Group V element and having a purity of at least about 99.9998%.

In another aspect, the present invention includes an apparatus for producing polycrystalline compounds having high purity and correct stoichiometry, comprising: an oven having at least one chamber; a container within the chamber having a first region for containing reactants and at least a second region for containing an encapsulant and a heating element; heater for the encapsulant; means for rotatably and vertically supporting and moving the container within the chamber; and a heater for the first and second regions of the container independently of each other. Preferably, said oven contains at least one window.

In a further aspect, the present invention includes an apparatus for producing polycrystalline compounds having high purity and correct stoichiometry, comprising: an oven having at least one vertically oriented chamber; a container within the chamber having a first region for containing reactants and a second region immediately above and adjacent to the first region for containing an encapsulant and a heating element for heating the encapsulant; a member connected to a motor for rotatably and vertically supporting and moving the container within the chamber; and an electrically powered inductive heating coil for inducing an electric current in the heating element when the heating coil is encircling the second region of the container while not heating the first region of the container, and for inducing an electric current in the reactants when the heating coil is encircling the first region of the container. Preferably, said container is associated with at least one other container. Preferably, a crucible is removably inserted within said container

## BRIEF DESCRIPTION OF THE DRAWINGS

The accompanying drawings, which are incorporated in and constitute a part of this specification, illustrate embodiments of the invention and, together with the description, explain the advantages and principles of the invention.

Fig. 1 is a cross-sectional view of an apparatus used to synthesize polycrystalline compounds in the stage prior to melting of the encapsulant consistent with an embodiment of the present invention.
Fig. 2 is a similar view to Fig. 1 in the stage after the encapsulant has melted and surrounded the reactants.
Fig. 3 is a similar view to Fig. 2 in the stage after the encapsulated reactants have melted.
Fig. 4 is a diagram showing power of the heating coil vs. time for CdTe during practice of the process of the present invention.
Fig. 5A is a cross-sectional view of a conventional apparatus for closed ampoule PVT growth of monocrystals.
Fig. 5B shows a typical thermal profile of an oven for PVT growth of monocrystals.
Fig. 6 is a similar view to that in Fig. 1 of another embodiment of the present invention showing a modified container having a seed pocket in the bottom below the reactants.
Fig. 7 is a similar view to that in Fig. 1 of another embodiment of the present invention showing a rod above the container for inserting a seed crystal into the encapsulated melt.

It is to be understood that both the foregoing general description and the following detailed description are exemplary and explanatory only and are not restrictive of the invention, as claimed. The following description, as well as the practice of the invention, set forth and suggest additional advantages and purposes of this invention.

## DETAILED DESCRIPTION

The present invention provides a novel process and apparatus for producing novel polycrystalline compounds as well as novel monocrystals formed from such compounds for use in a wide variety of semiconductor applications. The present invention further provides novel encapsulated reactant compositions from which the above-mentioned novel polycrystalline compounds and monocrystals can be produced.

The present invention provides a process and apparatus for producing crystalline compounds of high purity and of correct stoichiometry.

In this context, "high purity" is defined as a purity of at least about 99.999%, preferably at least about 99.9997% and most preferably about 99.9999% for polycrystalline compounds. In the context of monocrystals, high purity is defined as a purity of at least about 99.999, preferably at least about 99.99998%, and most preferably about 99.99999%. In general, the degree of impurity of a sample of a substance is calculated by evaluating the ratio, expressed as a percentage, between the weight of the impurity, contained in the sample, having the largest weight and the total weight of the sample. The degrees of purity is defined as 1 minus the degree of impurity. In addition, it is common in this art to express the purity of a sample by indicating how many of the first figures are equal to "9" in the degree of purity defined above. Thus, for a degree of purity equal, for example, to 99.99%, a purity of 4N is indicated. Consequently, a purity of at least 99.998% is equal to a purity of at least about 5N. "Stoichiometry" deals with combining weights of elements and compounds using ratios that permit the calculation of the moles of one substance as related to the moles of another substance.

For the purposes of the present invention the term "charge" signifies the material introduced in a suitable container, comprising elements, compounds, dopants, and which, at the end of the process, form the synthesis or growth process product.

By the term "compound" it is meant a substance composed of atoms or ions of two or more elements in chemical combination having definite proportions by weight.

By the term "alloy" it is meant a mixture (liquid or solid) of two or more elements which can have various proportions by weight.

By the term crystal it is meant a homogeneous solid made up of an element, chemical compound or isomorphous mixture throughout which the atoms or molecules are arranged in a regularly repeating pattern.

The terms "monocrystal" and "single crystal" signify a crystal in which all parts have the same crystallographic orientation.

The term "polycrystal" signifies a material composed of aggregates of individual crystals.

Further, in the context of the present invention the terms "polycrystalline compound" and "monocrystalline compound" signify a compound or an alloy, which can comprise dopants, having respectively polycrystalline and monocrystalline structure.

The process of the present invention comprises several steps. First, stoichiometric amounts of at least two reactants are placed in a first region of a container. The process is especially well suited for preparing compounds from one or more reactants which are of high volatility below the melting point of the chosen encapsulant and/or which are volatile at a temperature close to the encapsulant melting point.

Applicant notes that, in accordance with the invention, it is avoided that before the encapsulant completely melts and covers the charge large amounts of these elements undergo sublimation and then are lost.

Suitable elements include Cd, Zn, Hg, Te, Se, Ga, As, In, Tl, Mg, Sb, Ge, Ag, Cu, P, Se, S. Preferably, at least one reactant is a Group II element and at least one reactant is a Group VI element or at least one reactant is a Group III element and at least one reactant is a Group V element.

The process is particularly suitable for CdTe, CdZnTe, and compounds having at least one of Cd, Hg, Se, Te, Zn, S, Sb, As, P, that are relatively more volatile, while the advantage is more limited for Bi, In, Ga, Te, that are less volatile.

Most preferably, the reactants are Cd and Te, alone, or in combination with one or more other elements or dopants. Suitable dopants include In, Cl, I, B, Al, Ga, Fe, Cu, Ag, Hg, Se, Zn, S, Se, Sb, As, P.

As an example, dopants can be added to the charge in order to obtain specific opto-electronic or structural properties. If dopants are used in a process according with the present invention they are added with the reactants at the beginning of the process.

The container into which the reactants are placed can itself be associated with one or more other containers. Preferably, the container is associated with a first associated container which, for purposes of clarity, but not by way of limitation, will hereinafter be referred to as a crucible. Most preferably, the container holds a crucible which itself contains a second associated container which, for purposes of clarity, but not by way of limitation, will hereinafter be referred to as a receptacle. One skilled in the art can easily determine suitable dimensions for the container, crucible and receptacle.

Advantageously, the ratio of the diameter to the height of the container is from about 1:5 to about 5:1. Preferably, the ratio of the diameter to the height of the container is from about 1:2 to about 2:1. Most preferably, the ratio of the diameter to the height of the container is about 1. Advantageously, the ratio of the diameter to the height of the crucible is from about 1:5 to about 5:1. Preferably, the ratio of the diameter to the height of the crucible is from about 1:3 to about 3:1. Most preferably, the crucible has a diameter to height ratio of about 0.7:1. Advantageously, the ratio of the diameter to the height of the receptacle is from about 10:1 to about 1:5. Preferably, the ratio of the diameter to the height of the receptacle is from about 5:1 to about 1:2. Most preferably, the receptacle has a diameter to height ratio of about 1.2:1.

Preferably, the container (or the crucible, if one is present) has two regions which are capable of being heated separately from each other and may be, but preferably are not, separated by a discrete barrier. The container may also have more than two regions. The container is supported by a member, preferably a shaft attached to a motor, that provides for vertical, horizontal, or rotational movement, or a combination thereof, of the container. Preferably, the member provides for vertical and rotational movement of the container. If synthesis and/or growth are to take place horizontally, the member should provide for horizontal and rotational movement.

In the context of the present invention, the terms "means for rotatably and vertically supporting" and "means for moving" comprise any device, mechanic, magnetic, elastic, electric, pneumatic, etc. that are suitable for the above described purposes.

The containers and shaft can be constructed from any suitable material, or combination of materials, known to those skilled in the art for such purposes. Suitable materials of construction include quartz, graphite, graphite coated quartz, $Al_2O_3$ and pyrolytic boron nitride (pBN) coated graphite. The use of pBN coated graphite or $Al_2O_3$ for any components of the apparatus that may come in contact with the encapsulant, reactants, polycrystalline compound or monocrystal is advantageous because it avoids the potential for silicon contamination inherent in the use of quartz. Consequently, the use of such materials would be expected to contribute to the production of high purity compounds.

Next, an amount of an encapsulant sufficient to completely surround the reactants when the encapsulant is in a molten state is placed in the container. Advantageously, the encapsulant is inert with respect to the containers, the reactants and the reaction product, will adhere to the reactants, the reaction product and the growing crystal without damaging the crystal, has relatively low melting point, suitable density and is easy to remove from the various components when the synthesis and/or growth is complete. Suitable encapsulants include for example KCl-NaCl 1:1 and $B_2O_3$. Preferably, the encapsulant is $B_2O_3$. Preferably, the molten state is a liquid. The encapsulant may be placed in the same region as the reactants or in a different region than the reactants.

Preferably, the encapsulant is in a second region, different to the region containing the reactants, and suitable for the transfer of the encapsulant in a molten state into the first region containing the reactants. Preferably the encapsulant is above and directly adjacent to the reactants. Most preferably, the encapsulant is in contact with the reactants.

Next, a heating element is placed in the second region, adjacent to the encapsulant, for heating the encapsulant. The heating element need not be, but preferably is, in contact with the encapsulant. Most preferably, the heating element is above and in contact with the encapsulant. The heating element should be capable of having a current induced in it to generate heat. Such a heating element is desirable because the encapsulant $B_2O_3$ is electrically insulating, thus it is not possible to induce a current in it directly to heat and melt it. Suitable heating elements include liquid gallium, liquid indium, other element or compounds with suitable low vapor pressure or combinations thereof, which are preferably placed in the receptacle within the crucible, as well as graphite, pBN-coated graphite, SiC (silicon carbide) discs that need not be placed in the receptacle. Most preferably, the heating element is a graphite disc coated with pBN to avoid solubilization of the graphite in the encapsulant and subsequent carbon contamination of the synthesized polycrystalline compound or contamination of the same by impurities contained in the graphite.

The container is placed in a chamber containing a heating system. Preferably, the chamber is in an oven, which can have a window through which the contents of the chamber can be viewed. The oven walls can be surrounded by fluid cooling tubing, operating in association with a conventional fluid circulation and refrigeration system. The fluid can be, e.g., water.

The chamber can be horizontally oriented, but, preferably, the chamber is vertically oriented. The heating system used can be any suitable heating system known in the art and may be stationary or movable vertically or horizontally. Preferably, the heating system is stationary. Suitable heating systems include graphite cylindrical heating elements, inductive heating coils and resistance heating elements. Resistance heating elements are electric elements that generate heat under an applied current.

Preferably, the heating system is an electrically powered inductive heating coil.

Preferably, the inductive heating coils are associated with a fluid cooling system. The cooling fluid can be, e.g., water. The cooling fluid circulates inside the coils in order to avoid their overheating and the breakage during operation. Furthermore, the fluid cooling system quickly lowers the coils' temperature when the heating apparatus is switched off. Most preferably, the heating coil comprises copper coil windings powered by a radio-frequency generator. Suitable dimensions for the heating system can be easily determined by one skilled in the art. Advantageously, if copper coil windings are used, they should have a diameter to height ratio from about 1:5 to about 10:1. Preferably the diameter to height ratio is from about 1:1 to about 2:1. Most preferably, the diameter to height ratio is about 1.7:1.

Applicants observe that the heating coils have to be such as to heat the element **32** without heating the reactants during the first heating step. Then, the height upper limit of the heating coils is not critical.

An environment of inert gas is created in the chamber. Suitable inert gases can easily be determined by one of skill in the art and include argon and nitrogen. In general a gas of one of the components can be used. An inert gas, however, is preferred in order to avoid corrosion and safety problems.

The environment is then pressurized. Preferably, the environment is pressurized to a pressure substantially above the vapor pressure of the most volatile of the reactants at a selected maximum operating pressure. Preferably, the maximum operating temperature is higher than the melting temperature of the polycrystalline compound. More preferably, the environment is pressurized to a pressure of between about 10 atm and about 100 atm.

Most preferably, the environment is pressurized to a pressure of between about 20 atm and about 40 atm. If the reactants are Cd and Te the most preferred pressure is 20 atm.

Next, the heating element is heated to a temperature sufficient to melt the encapsulant. The heating element can be heated by any suitable means known to those skilled in the art that will allow the region containing the heating element to be heated without heating the region containing the reactants. Preferably, the heating element is heated by means of the heating system. Most preferably, the container is arranged within the chamber such that the region containing the heating element is within the ambit of the inductive heating coils, while the first region containing the reactants is outside the ambit of the inductive heating coils. Power is then supplied to the inductive heating coils sufficient to induce an electric current in the heating element which in turn heats and melts the encapsulant without inducing a current in the reactants in the first region. Preferably, the encapsulant is heated to a temperature which is at least the melting point of the encapsulant. As the heating of the encapsulant does not induce any current in the region in which the reactants are placed, vaporization of the reactants is minimized, what aids in the conservation of stoichiometric ratios.

As the encapsulant melts, it moves into the region containing the reactants and surrounds the reactants. The region containing the reactants is not heated during the melting of the encapsulant and is thus maintained at a temperature sufficient to avoid vaporization of the reactants. This does not mean that no vaporization of the reactants occurs, rather it means that any vaporization that does occur is negligible and does not significantly impact the stoichiometry of the polycrystalline compound formed. Because the lower region containing the reactants is only heated after the reactants have been coated with the molten encapsulant, vaporization is minimized, further contributing to the synthesis of products having correct stoichiometry. Furthermore, because the reactants are not heated during the heating of the encapsulant, the length of time during which the polycrystalline compound experiences high temperatures is shortened and contamination by the materials which make up the crucible, or container, is reduced. Moreover, the production of polycrystalline compounds having correct stoichiometry and low impurity content improves the quality of the monocrystals grown from such compounds.

According to one aspect of the present invention, the reactants surrounded by the molten encapsulant constitutes an inventive product. The reactants surrounded by molten encapsulant can be cooled to a temperature below the melting point of the encapsulant such that the encapsulant solidifies around the reactants. The inventive product can then be removed from the container for polycrystalline compound synthesis at some later time according to the further process of the present invention or according to another process.

After the reactants are surrounded by molten encapsulant, they are heated by bringing the region containing the reactants surrounded by molten encapsulant within the ambit of the heating system. To accomplish this, either the container can be moved so that the region containing the reactants is in the position previously occupied by the region containing the heating element, or the heating system can be moved so that instead of being positioned around the region containing the heating element, it is positioned around the region containing the reactants. Preferably the container is moved to bring the reactants within the ambit of the heating system. Most preferably the container is moved vertically to a position where the heating coils encircle the region containing the reactants.

The reactants are heated by the heating system to a temperature sufficient to melt the reactants and cause the reactants to react with each other and form a reaction product. Preferably, the reactants are heated to a temperature which is at least the melting point of the highest melting reactant. Preferably, the reactants are heated by direct induction of electrical current from heating coils, thereby avoiding the use of heating materials, such as graphite, which can contaminate the compound and degrade the purity of the resulting product. The reaction product is then heated to a temperature sufficient to melt the reaction product and for a time sufficient to synthesize and homogenize the reaction product. Preferably, the reaction product is heated to a temperature which is at least the melting point of the reaction product. Preferably, the reaction product is rotated, by rotation of the container, during melting, synthesis and homogenization.

Next, the reaction product is cooled to a temperature below the melting point of the reaction product but above the melting point of the encapsulant such that the reaction product solidifies and the encapsulant remains molten.

Then, the heating system is switched off and the encapsulant cools and solidifies.

Furthermore, the cooling phase is made quicker by the fluid cooling tubing system associated with the oven.

The encapsulant can at this point be removed by plunging the container of the reaction product in water, $H_2O$, or in alcohol (ethylic or methylic). The encapsulant then softens and, since the compound remains solid, their separation takes place.

In water the container may break because of the encapsulant expansion while in alcohol the expansion is less rapid and the container can be preserved.

Quartz containers are less expensive than pBN ones.

The encapsulant can be dissolved also by means of ultrasonic waves softening the encapsulant and having no effect on the compound.

The reaction product can be cooled by any suitable cooling means known to those skilled in the art.

The apparatus comprising a water-cooled heating system and a water-cooled oven has low heating inertia.

Such a system offers the possibility of producing rapid cooling ramps which makes it possible to synthesize even alloys with a relatively large number of reactants or with dopants while avoiding segregation and thus makes possible the following growth of crystals from such alloys. The polycrystalline compound reaction products of the present invention can be used to grow monocrystals of high purity and correct stoichiometry and can be used in any growth process and apparatus as further discussed below.

The following further detailed description refers to the accompanying drawings. The same reference numbers identify the same or similar elements. The description includes exemplary embodiments, however, other embodiments are possible, and changes may be made to the embodiments described without departing from the spirit and scope of the invention. Rather, the scope of the invention is defined only by the appended claims. In the description, reference will be made, for simplicity, to the synthesis and growth of CdTe. However, it will be clear to those skilled in the art that the inventive concepts described are also applicable to the synthesis and growth of other compounds and alloys of the family II-VI such as, for example, binary, ternary or quaternary compounds and alloys such as CdSe, ZnTe, ZnSe, and ZnCdTe and semi-magnetic compounds and alloys such as HgMnTe and CdMnTe, as well as materials doped with suitable elements, e.g., n or p type dopants.

The same inventive process and apparatus can also be extended to the synthesis of certain Group III-V compounds and alloys, antimonides, arsenides and ternary compounds. The process and apparatus of the present invention can be employed effectively even in the synthesis of polycrystalline compounds other than Group II-VI or III-V compounds and alloys including, for example, $CuInSe_2$, $AgGaSe_2$, $AgGaTe_2$, $CdGeAs_2$, InS with minor variations in the choice of the characteristic parameters that will be readily determinable by those skilled in the art.

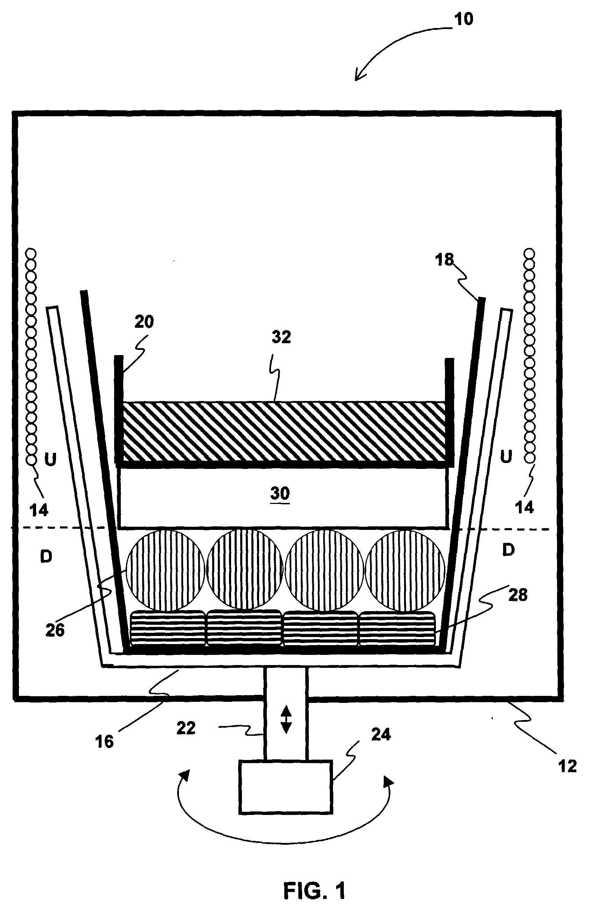

Fig. 1 is a diagram of a preferred embodiment of an apparatus consistent with the principles of the present invention which is appropriate for the synthesis of, for example, a CdTe compound suitable for growing a monocrystal. The apparatus includes an oven **10** within which is a vertically oriented chamber **12** inside which is an inductive heating coil **14,** including a container **16** which preferably contains a crucible **18**. A receptacle **20** can be inserted into the crucible **18**. The container **16** is mounted onto a shaft **22** solidly connected to a motor **24** so as to allow, with respect to the heating coil **14**, the rotation and vertical translation of the container **16** and, with it, of the crucible **18** and of the receptacle **20**. Preferably, the container and receptacle **16** and **20,** the crucible **18** and the shaft **22** are made of quartz. Preferably, the oven **10** also has windows, which allow the inside of the apparatus to be seen.

More preferably, the oven **10** walls are surrounded by water cooling tubing operating in association with a conventional fluid circulation and refrigeration system (not shown in the figure). The fluid can be, e.g., water.

A preferred process for synthesizing compounds, in accordance with the principles of the present invention, will become clear from the description of a process carried out by the Applicant for the synthesis of CdTe using the above-described novel apparatus of Fig. 1.

The synthesis process was monitored and controlled by viewing the contents of the chamber through the above-mentioned window. In particular, the state changes (melting, solidification) of the encapsulant and the charge and the chemical reactions of the charge was directly observed and/or deduced by color changes of the charge, in a way apparent to the skilled in the art.

The melting point of the boron oxide encapsulant is $T_m = 450°C$ or $T_m723°$.

Te has a melting point $T_m = 430°C$. The vapor pressure of Te, $P^0_{Te}$ (in bar), can be calculated, for any temperature T (in °K), from: $\log P^0_{Te} = 4.7191-5960.2/T$. The tellurium vapor mainly (95%) consists of diatomic molecules, i.e., $Te_2$. The vapor pressure of $Te_2$ at the melting point of the $B_2O_3$ is

$$P^0_{Te2} (723 °K) = 3·10^{-4} \text{ bar}.$$

Cd has a melting point $T_m = 320°C$. The vapor pressure of Cd, $P^0_{Cd}$ (in bar), can be calculated, for any temperature T in (°K), from the following relation: $\ln P^0_{Cd} = 26.15-13859/T-1.8415 \ln T$.

The vapor pressure of Cd, $P^0_{Cd}$, at the melting point of the $B_2O_3$ is $P^0_{Cd}(723°K) = 5.8 \cdot 10^{-3}$ bar. Thus, one can see that Cd is more volatile than Te (because it has a higher vapor pressure) and that the melting points for both Cd and Te are below the melting point of $B_2O_3$.

Applicant observes that according to conventional methods the complete melting of the $B_2O_3$ is reached when the reactants have temperature greater than 450°C, then their actual vapor pressures are even higher than the above mentioned values.

Consequently, prior to the present invention, the use of an encapsulant such as $B_2O_3$ in the synthesis of CdTe or similar compounds starting from at least one low fusing and/or high volatility reactant was not feasible because prior art methods could not avoid heating the reactants during heating of the encapsulant to its melting point.

## Example 1

In a first stage of a preferred process, that of preparation of the charge, the reactants Cd **26** and Te **28** were placed in the crucible **18** in stoichiometric amounts: 200.03g of Cd and 227.08g of Te.

A 30g pellet of $B_2O_3$ encapsulant **30** approximately 3 cm in height was placed on the reactants **26** and **28**. The melting point of the boron oxide encapsulant is $T_m$ = 450°C.

The charge (reactants **26** and **28**) occupied a first, lower region D of the crucible **18**. A receptacle **20** containing a heating element **32** was placed on the pellet of encapsulant **30**. The heating element **32** consisted of about 60 g of liquid gallium.

Encapsulant **30** and receptacle **20** occupied a second, upper region U of the crucible **18.**

The heating element **32** was used to heat the encapsulant **30**. Because $B_2O_3$ is electrically insulating it is not possible to induce a current directly in it by the heating coil **14**.

The crucible **18** thus assembled was placed in the container **16**. The chamber **12** was pressurized with argon gas, of high purity (99.999%) at 20 atm. This value is greater than the vapor pressure of Cd and $Te_2$ in equilibrium with CdTe at 1110°C, i. e., the highest temperature envisaged in the crucible.

The container **16** was then vertically positioned such that the heating coil **14** encircled only the upper region U of the crucible **18**, corresponding to the region occupied by the heating element **32**, as shown in Fig. 1.

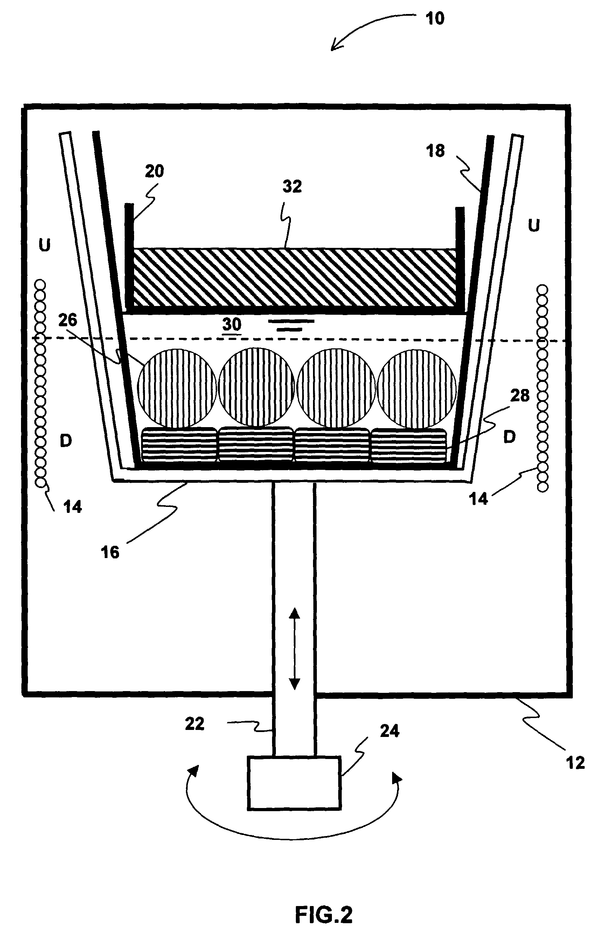

Next, power was supplied to the heating coil **14** so as to induce heat in the heating element **32** which transmitted it to the pellet of encapsulant **30**. The encapsulant **30** was softened and melted, initially in its top part, i.e. the part closest to the heating element**32**, and then a first layer of liquid encapsulant covered the contents of the crucible**18**. Finally, the encapsulant **30** melted completely as illustrated in Fig. 2.

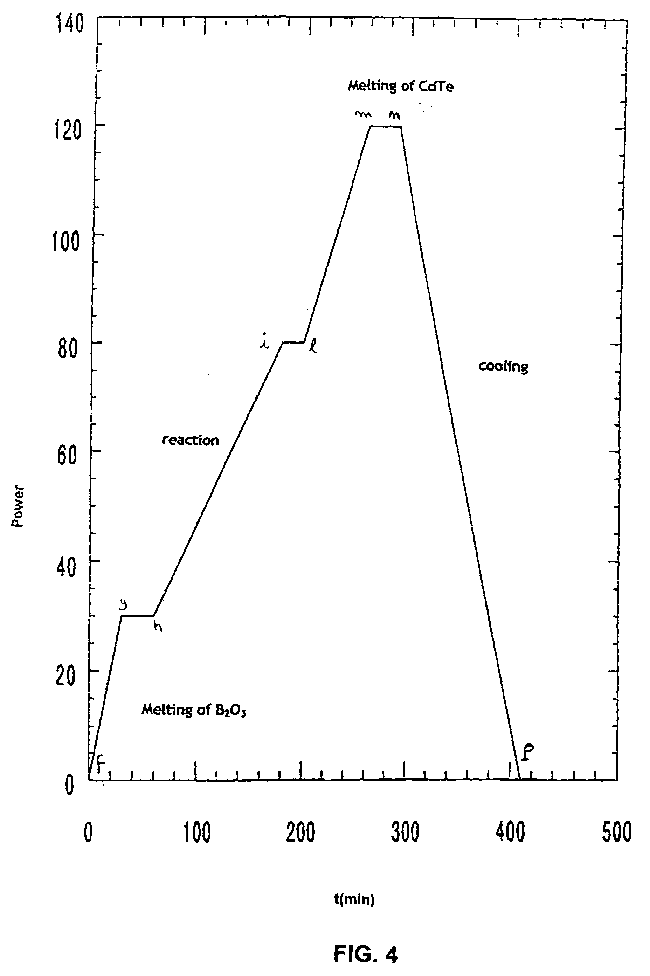

Fig. 4 is an approximate power-time diagram of the synthesis process in accordance with the present invention. In this diagram the power has been expressed in arbitrary units. The first line f-g corresponds to melting of the $B_2O_3$ encapsulant **30**. The liquefaction had a duration of about 30 minutes. The melting of the encapsulant took place without heating the region D of the crucible **18**, thus maintaining the temperature of this region at a value which did not cause volatilization of the reactants. The line g-h corresponds, approximately, to a waiting time necessary for the covering of the charge.

Applicants have been ensured of the completely covering of the charge by observing the contents of the chamber through the above-mentioned window.

The quantity of gallium inside the receptacle **20** was such to let the receptacle **20** float on the molten encapsulant 30. Alternatively the receptacle 20 can be fixed at the container **16** walls.

Next, the container **16** was moved vertically so as to bring the lower region D of the crucible **18** containing the reactants **26** and **28** and the molten encapsulant **30** within the ambit of heating coil **14** as shown in Fig. 2. The supply power to the heating coil **14** was then gradually raised, causing the reactants Cd **26** and Te **28** to melt and then react together exothermically, this reaction being accompanied by a flash of light. In Fig. 4, the line h-i shows the power-time relationship for the reaction phase. The reactants **26** and**28** were heated only after they had been completely coated with the molten $B_2O_3$ encapsulant **30**, thereby preventing them from being lost by vaporization during the reaction phase. Importantly, the heating of the reactants **26** and **28** took place by exploiting their intrinsic electrical conductivity, thus directly inducing a current in them and avoiding the use of heating elements, made of graphite or other materials, to support the crucible **18.**

Line i-l corresponds to a pause between the reaction phase and the following melting phase (l-m). Its duration is not critical and this phase can be even omitted.

Next, in order to melt and homogenize the liquid and to ensure complete reaction of the reactants, the power of the heating coil **14** was further increased, line l-m, so as to melt the reacted CdTe (the melting point of CdTe is $T_{CdTe}$ = 1092°C). During this state, the crucible **18** (by means of the shaft **22** and the container **16**) was rotated at a speed of 5-10 rpm (revolutions per minute) for about 30 minutes. Line m-n corresponds to the phase needed to reach homogenization of the molten compound.

Applicants observed trough the suitable window and the molten encapsulant, that is transparent, the melting of the reacted compound, producing a bright yellow color.

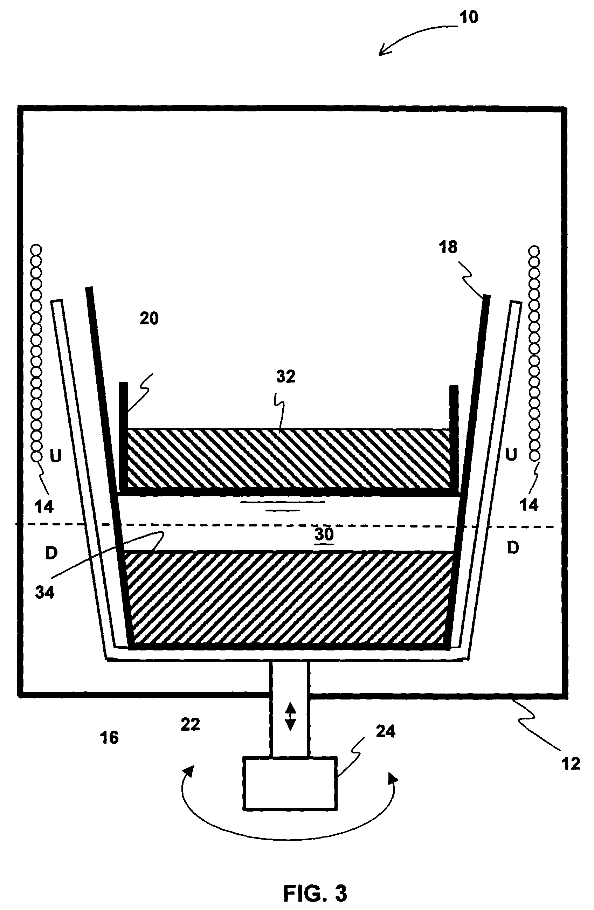

The compound was cooled by reducing the power of the heating coil **14** as shown in Fig. 4 (line n-p) over about 120 minutes while at the same time moving the first container **16** downwards as in Fig. 3. In this situation, the reacted CdTe **34**, solidified while the layer of encapsulant **30** was maintained in a liquid state.

Since $B_2O_3$ has a weight density less than the one of CdTe the layer of encapsulant **30** floated on the reacted compound of CdTe **34**.

The synthesis process was monitored and controlled by viewing the contents of the chamber through the above-mentioned window.

The apparatus described allowed a rapid cooling, also because the pressurized environment of the oven had high thermal conductivity that ensured a relatively high heat loss from the apparatus walls.

Then, the radio-frequency power feeding the heating system was switched off and the encapsulant cooled.

The water-cooling in the heating system and the oven allowed a quick cooling of the encapsulant.

The crucible **18** was removed from the chamber **12** when the system had returned to room temperature.

Applicant observed no condensation of reactants on the walls of the chamber **12**. This demonstrates that, during the process, there was no escape of gaseous reactants through the encapsulant **30**. Further proof of this was obtained by weighing the synthesized CdTe compound, which revealed no significant decrease in weight relative to the initial amounts of reactants **26** and **28**.

Applicant observes that, in the case of synthesis of doped charges or of alloys the cooling speed can be appropriately increased in order to avoid segregation of the reactants or the dopants. This is made possible by the apparatus of the present invention which has a low heat inertia.

Other temperature ramps different from the one shown are possible, these being easily adapted by those skilled in the art, and are particularly useful in the synthesis of ternary and quaternary compounds or alloys or when dopants are used, to avoid segregation of the reactants or of the dopants. The pressure to be exerted in the chamber **12** for the synthesis of compounds different from CdTe can also be easily determined by a person skilled in the art.

The polycrystalline compound obtained was compared with a market available polycrystalline compound acquired from ESPI, Italy. These polycrystalline compounds were analyzed, to evaluate the content in parts per million by weight (ppmw) for each impurity detected (ppmw = weight of impurity [μg] / weight of compound [g]).

Table 1 gives the results of the analyses performed. The first column gives the chemical symbols of the possible impurities, while the second and third columns give the corresponding ppmw values for the comparison sample of the polycrystalline compound and for the one produced according to the process described in Example 1, respectively. An empty position in the table corresponds to the absence of measurable amount of an impurity.

## Table 1

| | CdTe Comparison sample | CdTe Example 1 |
|---|---|---|
| Element | ppmw | ppmw |
| Li | 0.003 | 0.003 |
| Be | | |
| B | 0.027 | 3.4 |
| F | | |
| Na | 0.045 | 0.007 |
| Mg | 0.16 | 0.13 |
| Al | 1.7 | 0.011 |

| | | |
|---|---|---|
| Si | 0.83 | 0.25 |
| P | 0.013 | 0.003 |
| S | 0.69 | 0.018 |
| Cl | 200 | 0.047 |
| K | 0.023 | 0.007 |
| Ca | 0.1 | 0.019 |
| Sc | | |
| Ti | 0.038 | |
| V | 0.003 | |
| Cr | 0.017 | 0.004 |
| Mn | 0.021 | 0.008 |
| Fe | 0.59 | 0.09 |
| Co | 0.18 | 0.001 |
| Ni | 0.64 | 0.002 |
| Cu | 0.3 | 0.018 |
| Zn | 0.076 | 0.007 |
| Ga | | |
| Ge | | |
| As | 0.64 | 0.03 |
| Se | 0.45 | 3.8 |
| Br | | |
| Rb | | |
| Sr | | |
| Y | | |
| Zr | | |
| Nb | | |
| Mo | 0.037 | 0.003 |
| Ag | 0.017 | |
| In | 1.3 | |
| Sn | 0.27 | |
| Sb | 3.1 | |
| I | | |
| Tl | 0.055 | |
| Pb | 9.5 | |

| | | |
|---|---|---|
| Bi | 0.083 | |
| Th | | |
| | | |
| PURITY | 99.98% | 99.9997% |

It is clear from Table 1 that many of the impurities which are found in the comparison polycrystalline compound (in particular the elements Ti, V, Ag, In, Sn, Sb, Tl, Pb, Bi) are not present in the compound produced by the process and apparatus of the present invention. Although higher amounts of B and Se are present in the inventive polycrystalline compound, as discussed below, these levels are not of concern in the growth and performance of monocrystals. Specifically, Applicant assumes that the Se comes from the impurities thereof present in the Te reactant, and thus its presence is independent of the synthesis process.

Furthermore, because the Se is isoelectric with Te, its electronic properties are such that it does not adversely affect, at these concentrations, the behavior of CdTe in optoelectronic applications.

Applicant has performed another syntheses of a CdTe polycrystal by means the method according to the invention and above described using a Te sample acquired from a different provider (Japan Energy). In this case, Applicant has found, in the CdTe polycrystal, a very low quantity of Se, i.e., 0.052 ppmw.

Moreover, B, as shown below, is not incorporated in vapor-phase growth processes.

G.W. Blackmore et al. "Boron segregation in Czochralski-Grown CdTe" J. of Crystal Growth, pp. 335-340, vol. 8 (1987) describe that chemical analysis of CdTe ingots grown by the liquid encapsulated Czochralski technique using $B_2O_3$ encapsulant show that the material contains up to 90 ppma boron and that boron distribution is non-uniform. Authors of the article note that the observation of low carrier concentration and high electrical mobility in this material also supports the thesis that most of the boron is not electrically active. In this article the concentrations are expressed in "ppma", atomic part per million.

The polycrystalline CdTe obtained in example 1 according to the present invention has a boron concentration of 3.4 ppmw, which corresponds to 75.48 ppma. The conversion formula is: 1 ppma = (CdTe)/M(B) x 1 ppmw = 240/10.81 ppmw = 22.2 ppmw ; where M(CdTe) is the formula weight of CdTe and M(B) is the boron atomic weight.

Applicants observes that the boron concentration of the material analyzed in the above mentioned article is greater than the boron concentration of the sample synthesized in accordance with the invention.

As for the other impurities detected (Na, Mg, Al, Si, P, S, Cl, K, Ca, Cr, Mn, Fe, Co, Ni, Cu, Zn, As, Mo), the amounts found in the compound produced by the process and apparatus of the present invention are all substantially lower than the amounts in the commercially available ESPI product.

According to the results of the analyses shown in Table 1, the polycrystalline compound acquired from ESPI has a degree of purity equal to 99.98%, i.e. a purity of about 4N. However, the polycrystalline compound produced by the process and apparatus of the present invention has a degree of purity equal to 99.9997%, i.e. a purity of more than 5N.

The method of synthesis described is compatible with any method of growth. The apparatus and growth methods described in the following examples are illustrative and are particularly advantageous for use in the practice of the present invention.

### Example 1A

Applicant has synthesized a CdZnTe alloy (Group II-II-VI) having a Zn quantity percentage of 20%. Zn has melting point $T_m$=419.5°C.

In a first stage of a preferred process, that of preparation of the charge, the reactants Cd, Zn, Te, were placed in the crucible **18** in stoichiometric amount: 139.37 g of Cd, 20.27 g of Zn, 197.78 g of Te.

The charge has a total weight of 357.42 g.

A pellet **30** of about 30 g of $B_2O_3$ encapsulant was placed on the reactants.

The reactants occupied a lower region D of the crucible **18**.

A receptacle **20** containing a heating element **32** was placed on the pellet of encapsulant **30**. The heating element **32** consisted of about 60g of liquid gallium.

Encapsulant **30** and receptacle **20** occupied an upper region U of the crucible **18.**

The synthesis process has been carried out in a manner analogous to the one described in detail in the Example 1 with reference to figures 1-4. The process parameters (temperatures, times, pressures, etc.) were adapted according to known techniques.

In order to avoid Zn segregation the cooling was effected by suitably reducing the power of the heating coils **14** and at the same time moving the first container **16** downwards as in Fig. 3.

The crucible **18** was removed from the chamber **12** when the system had returned to room temperature. Also in this case, Applicant observed no condensation of reactants on the walls of the chamber **12**. This demonstrates that, during the process, there was no escape of gaseous reactants through the encapsulant **30**. Further proof of this was obtained by weighing the synthesized CdZnTe compound, which revealed no significant decrease in weight relative to the initial amounts of reactants.

## Example 2

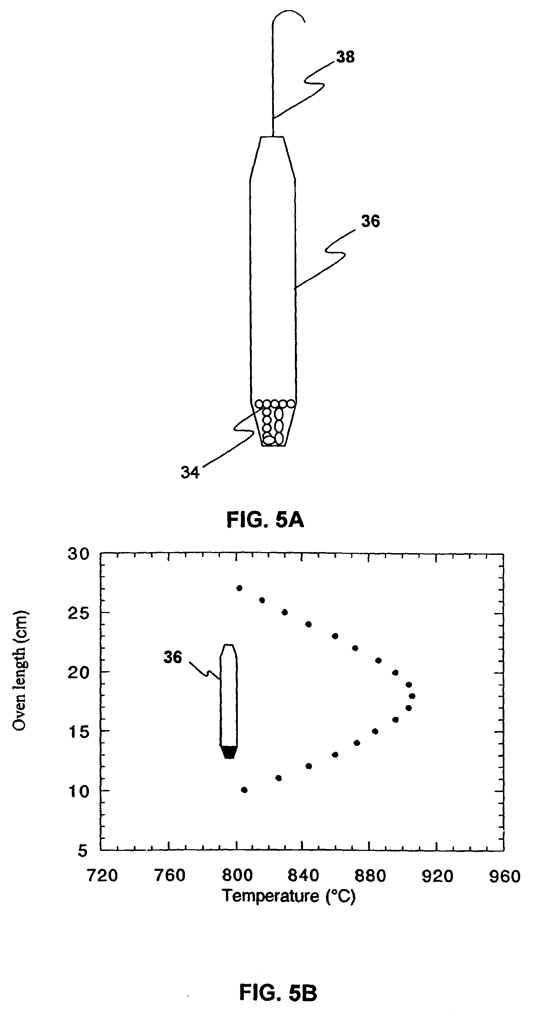

Applicants grew two CdTe monocrystals from polycrystalline compounds synthesized by the process and apparatus of the present invention. Both crystals (Crystal 1 and Crystal 2) were grown by the PVT (Physical Vapor Transport) method, as described in the above-mentioned article by Yellin, N. and Szapiro, S., "Vapor Transport of Nonstoichiometric CdTe in Closed Ampoules", J. of Crystal Growth, Vol. 9, No. 2-3, pp. 555-60. With reference to Fig. 5A, 10-20 g of polycrystalline CdTe **34** prepared according to the process and apparatus described in Example 1, were placed inside a quartz ampoule **36** connected to a pulling rod **38** and closed with a vacuum of greater than $10^{-5}$ mbar. The quartz ampoule **36** containing the polycrystalline CdTe **34** was then placed inside a vertical oven (not shown in figure) having a temperature profile of the type shown in Fig. 5B. The quartz ampoule **36**, initially placed relative to the temperature profile of the oven as shown in the figure, was then moved, by means of the pulling rod **38**, upwards relative to this oven. Supersaturation of the Cd and Te vapors thus causes the condensation of a solid phase only when the pressure inside the ampoule is such that it does not inhibit mass transport. Table 2 gives the boron concentration values determined in the synthesized polycrystalline sample and in two crystals grown by the described vapor phase technique. The value for B (main impurity in the polycrystal) is reduced by one/two orders of magnitude in the crystal grown in the vapor phase, indicating that B is not incorporated in vapor phase growth. The crystals thus obtained had purities of 6/7N.

Table 2

| Sample | Boron concentration (ppmw) |
|---|---|
| Polycrystalline CdTe | 3.4 |
| CdTe Crystal 1 | 0.36 |
| CdTeCrystal 2 | 0.19 |

As noted in the Yellin and Szapiro article on p. 556, mass transport growth is completely inhibited if the stoichiometry of the polycrystalline charge is shifted towards Cd by a fraction greater than 0.01 mol%, and the rate of growth is reduced considerably if the stoichiometry of the polycrystalline charge is shifted towards tellurium by a fraction greater than 0.04 mol%. Repeated laboratory tests demonstrate that the polycrystalline CdTe compounds synthesized according to the process and apparatus of the present invention allow mass transport growth in a closed ampoule, thus indicating that the polycrystalline CdTe compound has a stoichiometric shift which is appreciably lower than these levels.

Applicants have determined that also other polycrystalline compounds synthesized according to the process and apparatus of the present invention have low stoichiometric shift (e.g. correct stoichiometry) due to the fact that the reactants can be encapsulated before reaching a temperature at which any meaningful vaporization occurs.

## Example 3

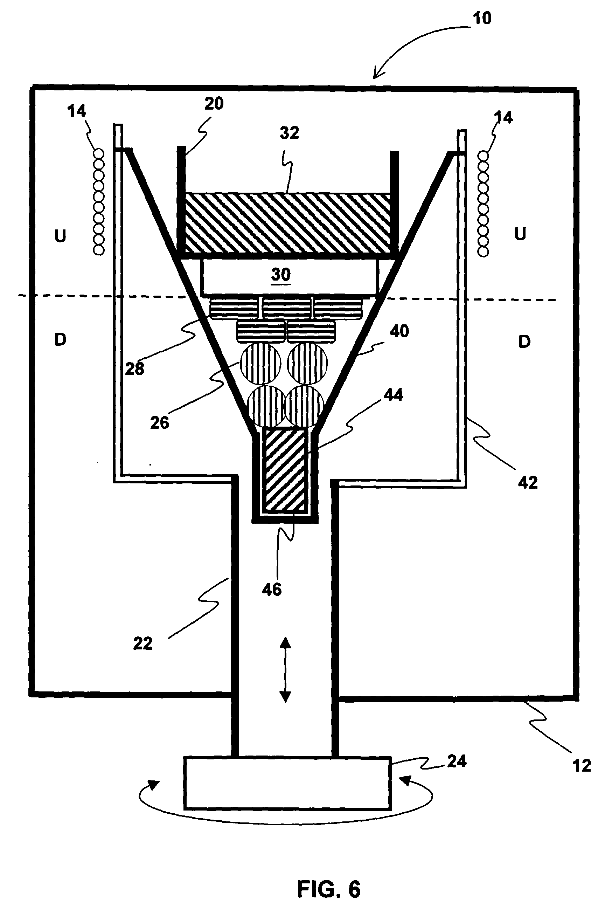

Fig. 6 shows apparatus which allows the synthesis of a polycrystalline compound in a manner similar to that described with reference to Fig. 1, and also allows the monocrystal to be grown in a subsequent stage according to the Vertical Bridgman method.

The container **16** and flat-bottomed quartz crucible **18** of Fig. 1 can be replaced with a container **42** and a crucible **40** which has at the center a housing or pocket **46** in which a seed monocrystal **44** of the material which is to be synthesized and grown (e.g. CdTe) can be placed.

Once the encapsulant (e.g., B₂O₃) **30** is molten, the crucible **40** is raised as shown in Fig. 2 in order to melt reactants (e.g., Cd **26** and Te **28**) and to obtain the reaction product as described in Example 1. Up to this point, the CdTe seed **44** remains solid, since the melting point for CdTe is higher than the reaction temperature. Next, the temperature is increased and the CdTe is melted. In this stage, the heating should be carried out such as not to completely melt the CdTe seed **44** introduced. This is possible by using an appropriately sized and/or positioned induction heating coil **14** and by controlling the heating ramp during the stage of melting of the polycrystal (Fig. 4 l-m, m-n). Growth can then take place as in a typical Vertical Bridgman method.

The seed crystal **44** produces a lattice structure on which the molten compound can grow during a suitable cooling realized by lowering the crucible **40** by means of the movement of the container **42**. During the cooling, the seed crystal **44** and the grown crystal are at a temperature lower then the corresponding melting point while the upper growing compound is kept in the molten state.

The suitable thermal gradient and the growing times are apparent to those skilled in the art.

In order to obtain an adequate temperature profile, additional heating elements of suitable shape can be introduced around the crucible **40.**

### Example 4

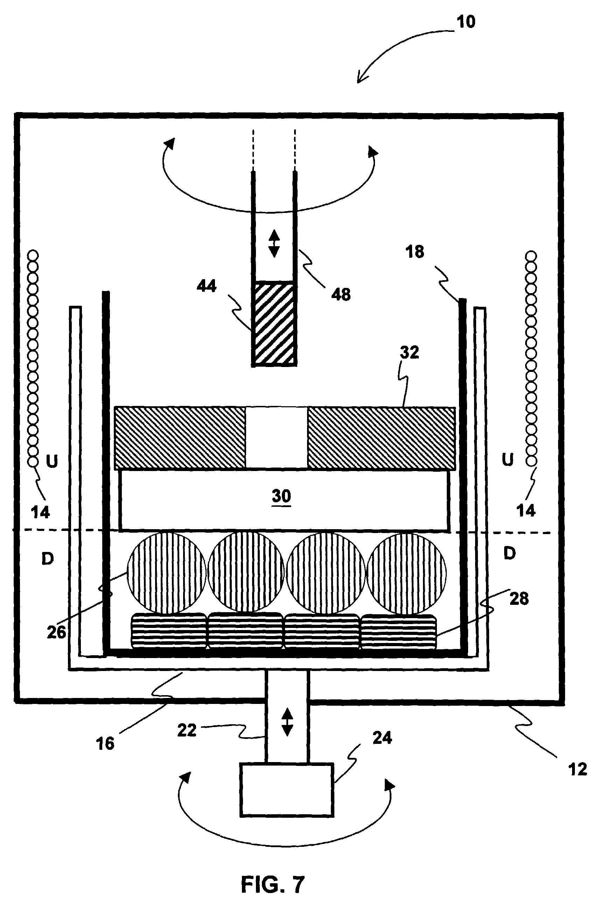

Fig. 7 shows apparatus which allows the synthesis of a polycrystalline compound according to another embodiment of the present invention in a manner similar to that described in Example 1, and which also allows a monocrystal to be grown according to the Czochralski method. To achieve this end, the receptacle **20** of Fig. 1 can be replaced with a graphite ring **32** with an outside diameter similar to that of the receptacle **20**, i.e., 3.5 cm, and an inside diameter greater than or equal to the diameter of the desired monocrystal (for example 2.5 cm). The ring can be mounted so as to float on the surface of the B₂O₃, but not to rotate with respect to the crucible **18.**

The synthesis then proceeds according to the method outlined in Example 1, except that heat is induced in the B₂O₃ **30** by means of the graphite ring **32**. Once the synthesis has taken place and the CdTe in the crucible has melted, the growth can take place immediately according to the Czochralski technique, for example, by solidly attaching a seed monocrystal **44** to a moveable rod **48** located in the top of the oven **10**, with the liquid CdTe maintained at a suitable temperature. The growth proceeds by plunging the rod in the liquid compound, trough the hole in the graphite ring **32**, and gradually raising the seed out of the molten mixture.

The apparatus of Figs. 6 and 7 can include a suitable intercepting member arranged in the crucible in order to modify the temperature gradient in the region of the growth interface. A suitable intercepting member for use in the apparatus is described, for example, in European patent EP 509,312 with reference to figures 5 and 6. This member, for example ring-shaped, intercepts the radiation generated from the heating coils providing to the charge the right thermal gradient.

Over all, the present invention provides numerous advantages for the syntheses and the growth of crystals.

These advantages include that the method and the apparatus described ensure a complete reaction of the elements and a correct stoichiometry. In addition, this method has no quantity product limits, no vapor losses, safety (Cd and Te can cause cancer), short synthesis time and employs a simple apparatus.

The foregoing description of preferred embodiments of the present invention provides illustration and description, but is not intended to be exhaustive or to limit the invention to the precise form disclosed. Modifications and variations are possible in light of the above teachings or may be acquired from practice of the invention. The foregoing description includes specific data values obtained through experimentation. These values serve as examples only and the true scope of the invention is defined only by the claims and their equivalents.

**Claims**

1. A process for producing Group II-VI or Group III-V polycrystalline compounds of high purity and correct stoichiometry, comprising the steps of:

   a) heating an encapsulant to a first temperature sufficient to melt said encapsulant;
   b) surrounding stoichiometric amounts of at least two reactants with said encapsulant in a molten state wherein during encapsulation said reactants do not achieve a temperature sufficient to cause vaporization of one or more of said reactants; and
   c) forming a polycrystalline Group II-VI or Group III-V compound.

2. The process of claim 1, wherein step (b) further comprises heating said reactants surrounded by said encapsulant to a second temperature sufficient to melt said reactants and cause said reactants to react with each other and form a reaction product; and heating said reaction product to a third temperature sufficient to melt said reaction product and for a time sufficient to synthesize and homogenize said reaction product.

3. A process for producing polycrystalline compounds of high purity and correct stoichiometry, comprising the steps of:

a) placing stoichiometric amounts of at least two reactants in a first region;
b) placing an amount of an encapsulant in a second region sufficient to completely surround said reactants when said encapsulant is in a molten state, said second region being suitable for the transfer of said encapsulant in a molten state into said first region and said first and second regions being capable of being heated separately from each other;
c) creating an environment of gas around said first and second regions and pressurizing said environment to a pressure substantially above the vapor pressure of the most volatile of said reactants at a selected maximum operating temperature;
d) heating said second region to a first temperature sufficient to melt said encapsulant while not heating said first region, said first region being maintained at a temperature sufficient to avoid vaporization of said reactants thus causing said encapsulant, in a molten state, to move from said second region into said first region and surround said reactants;
e) heating said reactants surrounded by said encapsulant to a second temperature sufficient to melt said reactants and cause said reactants to react with each other and form a reaction product; and
f) heating said reaction product to a third temperature sufficient to melt said reaction product and for a time sufficient to synthesize and homogenize said reaction product.

4. A process for producing polycrystalline compounds of high purity and correct stoichiometry, comprising the steps of:

a) placing stoichiometric amounts of at least two reactants in a first region of a container;
b) placing an amount of an encapsulant in a second region of said container sufficient to completely surround said reactants when said encapsulant is in a molten state, said second region being suitable for the transfer of said encapsulant in a molten state into said first region and said second region being immediately above and adjacent to said first region and said first and second regions being capable of being heated separately from each other;
c) placing said container in an enclosed vertically oriented chamber;
d) creating an environment of gas around said container and pressurizing said environment to a pressure substantially above the vapor pressure of the most volatile of said reactants at a selected maximum operating temperature;
e) heating said second region to a first temperature sufficient to melt said encapsulant while maintaining said first region at a temperature sufficient to avoid vaporization of said reactants thus causing said encapsulant, in a molten state, to move from said second region into said first region and surround said reactants;
f) heating said reactants surrounded by said encapsulant to a second temperature sufficient to melt said reactants and cause said reactants to react with each other and form a reaction product; and
g) heating said reaction product to a third temperature sufficient to melt said reaction product and for a time sufficient to synthesize and homogenize said reaction product.

5. The process of claim 4, further comprising the steps after step (g) of:

h) cooling said reaction product surrounded by said encapsulant to a temperature below the melting point of said reaction product but above the melting point of said encapsulant; and
i) separating said reaction product from said encapsulant.

6. The process of claim 4, wherein said reactants comprise at least one Group II element and at least one Group VI element.

7. The process of claim 4, wherein said reactants comprise at least one Group III element and at least one Group V element.

8. The process of claim 6, wherein said reactants are Cd and Te.

9. The polycrystalline compound produced in accordance with the process of claim 4.

**10.** The polycrystalline compound of claim 9, wherein said compound has a purity of at least about 5N.

**11.** A process for producing a monocrystal of high purity and correct stoichiometry from a polycrystalline compound produced by the process of claim 4, wherein the process further comprises the steps of:

> placing a seed monocrystal in a housing in said first region of said container,
> performing steps (a) through (g); and
> gradually lowering said container, relative to said chamber, such that the temperature of said first region is gradually reduced and said monocrystal is grown.

**12.** A process for producing an encapsulated reactant composition comprising the steps of:

> a) heating an encapsulant to a first temperature sufficient to melt said encapsulant; and
> b) surrounding stoichiometric amounts of at least two reactants with said encapsulant in a molten state before said reactants achieve a temperature sufficient to cause vaporization of one or more of said reactants wherein said reactants comprise at least one Group II element and at least one Group VI element.

**13.** A polycrystalline compound comprising at least one Group II element and at least one Group VI element and having a purity of at least about 99.998% and wherein none of the elements comprising said compound deviates from stoichiometric composition by more than about 0.01 mol%.

**14.** A polycrystalline compound comprising at least one Group III element and at least one Group V element and having a purity of at least about 99.998% and wherein none of the elements comprising said compound deviates from stoichiometric composition by more than about 0.01 mol%.

**15.** A process for producing a monocrystal of high purity and correct stoichiometry, comprising the steps of:

> a) heating an encapsulant to a first temperature sufficient to melt said encapsulant;
> b) surrounding stoichiometric amounts of at least two reactants with said encapsulant in a molten state before said reactants achieve a temperature sufficient to cause vaporization of one or more of said reactants wherein said reactants comprise at least one Group II element and at least one Group VI element;
> c) heating said reactants surrounded by said encapsulant to a second temperature sufficient to melt said reactants and cause said reactants to react with each other and form a reaction product;
> d) heating said reaction product to a third temperature sufficient to melt said reaction product and for a time sufficient to synthesize and homogenize said reaction product; and
> e) forming a monocrystal from said reaction product.

**16.** A process for producing a monocrystal of high purity and correct stoichiometry, comprising the steps of:

> producing an encapsulated reaction product according to the process of claim 12;
> heating said reaction product to a molten state;
> inserting a seed monocrystal into said reaction product; and
> gradually raising said seed monocrystal out of said molten reaction product.

**17.** A monocrystalline compound comprising at least one Group II element and at least one Group VI element and having a purity of at least about 99.9998%.

**18.** A monocrystalline compound comprising at least one Group III element and at least one Group V element and having a purity of at least about 99.9998%.

**19.** An apparatus for producing polycrystalline compounds having high purity and correct stoichiometry, comprising:

> an oven having at least one chamber;
> a container within said chamber having a first region for containing reactants and at least a second region for containing an encapsulant and heater for said encapsulant;
> means for rotatably and vertically supporting and moving said container within said chamber; and
> a heater for said first and second regions of said container independently of each other.

**20.** An apparatus for producing polycrystalline compounds having high purity and correct stoichiometry, comprising:

an oven having at least one vertically oriented chamber;
a container within said chamber having a first region for containing reactants and a second region immediately above and adjacent to said first region for containing an encapsulant and a heating element for heating said encapsulant;
a member connected to a motor for rotatably and vertically supporting and moving said container within said chamber; and
an inductive heating coil for inducing an electric current in said heating element when said heating coil is encircling said second region of said container while not heating said first region of said container, and for inducing an electric current in said reactants when said heating coil is encircling said first region of said container.

**FIG. 1**

**FIG.2**

FIG. 3

FIG. 4

**FIG. 5A**

**FIG. 5B**

**FIG. 6**

FIG. 7

## EUROPEAN SEARCH REPORT

**European Patent Office**

**Application Number**

EP 99 12 4302

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | EP 0 196 854 A (TOKYO SHIBAURA ELECTRIC CO) 8 October 1986 (1986-10-08) | 1,2,14, 18 | C30B11/00 C30B15/00 C30B29/48 C30B29/40 |
| Y | * page 8, line 20 - page 9, line 17 * | 19,20 | |
| Y | EP 0 141 649 A (SUMITOMO) 15 May 1985 (1985-05-15) * page 5, line 14 - page 6, line 16 * | 19,20 | |
| X | KLAUSUTIS: "Growth of CdTe1-xSex by the LEC and Bridgman Techniques" J.ELECTRONIC MATERIALS, vol. 4, no. 3, June 1975 (1975-06), pages 625-634, XP002103033 * page 628 * | 1,2,12, 13,16 | |
| Y,D | US 5 131 975 A (BOURRET-COURCHESNE EDITH D) 21 July 1992 (1992-07-21) * the whole document * | 1-18 | |
| Y,D | US 4 652 332 A (CISZEK THEODORE F) 24 March 1987 (1987-03-24) * column 3, line 3550 * | 1-18 | **TECHNICAL FIELDS SEARCHED (Int.Cl.7)** C30B |
| A | PATENT ABSTRACTS OF JAPAN vol. 016, no. 164 (C-0931), 21 April 1992 (1992-04-21) & JP 04 012081 A (SUMITOMO METAL MINING CO LTD), 16 January 1992 (1992-01-16) * abstract * | 1,4,11 | |
| A | PATENT ABSTRACTS OF JAPAN vol. 16, no. 228 (C-0944), 27 May 1992 (1992-05-27) & JP 04 046097 A (MITSUBSHI MATERIALS CORP) * abstract * | | |

-/--

The present search report has been drawn up for all claims

| Place of search | Date of completion of the search | Examiner |
|---|---|---|
| THE HAGUE | 2 March 2000 | Cook, S |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

EP 1 013 801 A1

**European Patent Office**

# EUROPEAN SEARCH REPORT

Application Number

EP 99 12 4302

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| A | US 4 824 520 A (MORRISON ANDREW D) 25 April 1989 (1989-04-25) | | |
| A | US 5 415 125 A (FUJITA HIROMOTO ET AL) 16 May 1995 (1995-05-16) | | |

TECHNICAL FIELDS SEARCHED (Int.Cl.7)

The present search report has been drawn up for all claims

| Place of search | Date of completion of the search | Examiner |
|---|---|---|
| THE HAGUE | 2 March 2000 | Cook, S |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

&  : member of the same patent family, corresponding document

EPO FORM 1503 03.82 (P04C01)

**ANNEX TO THE EUROPEAN SEARCH REPORT
ON EUROPEAN PATENT APPLICATION NO.**                    EP 99 12 4302

This annex lists the patent family members relating to the patent documents cited in the above-mentioned European search report.
The members are as contained in the European Patent Office EDP file on
The European Patent Office is in no way liable for these particulars which are merely given for the purpose of information.

02-03-2000

| Patent document cited in search report | | Publication date | Patent family member(s) | | Publication date |
|---|---|---|---|---|---|
| EP 0196854 | A | 08-10-1986 | JP | 61222911 A | 03-10-1986 |
| | | | CA | 1284761 A | 11-06-1991 |
| | | | DE | 3689272 D | 16-12-1993 |
| | | | DE | 3689272 T | 21-04-1994 |
| | | | US | 4816240 A | 28-03-1989 |
| EP 141649 | A | 15-05-1985 | JP | 60103097 A | 07-06-1985 |
| US 5131975 | A | 21-07-1992 | NONE | | |
| US 4652332 | A | 24-03-1987 | NONE | | |
| JP 04012081 | A | 16-01-1992 | NONE | | |
| JP 04046097 | A | 17-02-1992 | NONE | | |
| US 4824520 | A | 25-04-1989 | NONE | | |
| US 5415125 | A | 16-05-1995 | JP | 5139886 A | 08-06-1993 |

EPO FORM P0459

For more details about this annex : see Official Journal of the European Patent Office, No. 12/82